# EUROPEAN PATENT SPECIFICATION

(11) **EP 4 708 447 B1**
(45) Date of publication and mention of the grant of the patent: **28.10.2026**
(21) Application number: 25193328.9
(22) Date of filing: 01.08.2025
(51) Int. Cl.: H01M 10/42, G01R 31/392, H01M 10/48

(54) **BATTERY SYSTEM**
BATTERIESYSTEM
SYSTÈME DE BATTERIE

(30) Priority: 06.09.2024 JP 2024153897; 28.05.2025 JP 2025088850
(43) Date of publication of application: 11.03.2026
(73) Proprietor: TOYOTA JIDOSHA KABUSHIKI KAISHA, Toyota-shi, Aichi-ken 471-8571 (JP)
(72) Inventor: MATSUI, Takaaki, Toyota-shi, Aichi-ken, 471-8571 (JP); IRIE, Takayuki, Toyota-shi, Aichi-ken, 471-8571 (JP); HARA, Tetsuo, Toyota-shi, Aichi-ken, 471-8571 (JP); ISOBE, Koichiro, Toyota-shi, Aichi-ken, 471-8571 (JP)
(74) Representative: Winter, Brandl - Partnerschaft mbB

(56) References cited:
- CN-A- 118 501 744
- JP-A- 2015 141 790

## Description

### CROSS REFERENCE TO RELATED APPLICATIONS

This nonprovisional application is based on Japanese Patent Applications No. 2024-153897 filed on September 6, 2024 and No. 2025-088850 filed on May 28, 2025 with the Japan Patent Office.

### BACKGROUND

### Field

The present disclosure relates to a battery system.

### Description of the Background Art

Japanese Patent Laying-Open No. 2015-141790 discloses determining degradation with time of a battery constituent member using an internal pressure of a battery (battery internal pressure).

In the above publication, the amount of gas generated in the battery (gas generation amount) is calculated from the temperature of the battery and the history of SOC (State Of Charge). Then, the battery internal pressure is calculated based on the gas generation amount, and the internal pressure damage amount is obtained from the battery internal pressure.

The gas and an electrolyte solution in the battery slightly leak to the outside of the battery from the seal portion or the like. In the above publication, since the leakage of the gas or electrolyte solution is not considered, there is a concern that the calculation accuracy of the battery internal pressure deteriorates. Prior art documents JP2015 141790 and CN118 501 744 disclose battery diagnostic systems assessing the internal pressure.

### SUMMARY

An object of the present disclosure is to improve the calculation accuracy of the battery internal pressure.

A battery system according to the present disclosure includes: a battery in which an electrode assembly and an electrolyte solution are housed in a case; and a control device. The control device calculates an internal gas amount Vg that is a gas amount inside the battery, by subtracting, from a generation amount Vgo of gas generated in the case, a gas permeation amount Vgp corresponding to an amount of leakage of the gas out of the case; calculates an internal void volume Vc that is a void volume inside the battery, by adding, to an initial void volume Vc0 in the case, an electrolyte solution permeation amount Vep corresponding to an amount of leakage of the electrolyte solution out of the case; and calculates a battery internal pressure P that is a pressure in the case, based on the internal gas amount Vg and the internal void volume Vc.

According to this configuration, the control device calculates the battery internal pressure P based on the internal gas amount Vg and the internal void volume Vc. The internal gas amount Vg is calculated by subtracting the gas permeation amount Vgp corresponding to the amount of leakage of the gas out of the case, from the generation amount Vgo of the gas generated in the case. The internal void volume Vc is calculated by adding the electrolyte solution permeation amount Vep corresponding to the amount of leakage of the electrolyte solution out of the case, to the initial void volume Vc0 in the case. Since the battery internal pressure P is calculated in consideration of leakage of the gas and the electrolyte solution out of the case of the battery, the calculation accuracy of the battery internal pressure P can be improved.

Preferably, the control device may calculate the internal gas amount Vg by subtracting, from the generation amount Vgo, the gas permeation amount Vgp and a gas absorption amount Vga that is an amount of absorption of the gas by the electrolyte solution.

According to this configuration, since the internal gas amount Vg is calculated in consideration of the gas absorption amount Vga that is an amount of the gas absorbed by the electrolyte solution, it is possible to further improve the calculation accuracy of the battery internal pressure P.

Preferably, the control device may calculate the gas permeation amount Vgp based on the battery internal pressure P.

The amount of leakage of the gas out of the case correlates with the magnitude of the battery internal pressure P. According to this configuration, since the gas permeation amount Vgp is calculated based on the battery internal pressure P, the gas permeation amount Vgp can be calculated accurately.

Preferably, the control device may calculate a gas permeation rate A2 that is an amount of the gas leaking out of the case per unit time, based on the battery internal pressure P and an index value representing airtightness of the battery, and calculate the gas permeation amount Vgp based on the gas permeation rate A2.

The amount of leakage of the gas out of the case also correlates with the airtightness of the case. According to this configuration, the gas permeation rate A2 is calculated based on the battery internal pressure P and the index value representing the airtightness of the battery. Since the gas permeation amount Vgp is calculated based on the gas permeation rate A2, the gas permeation amount Vgp can be calculated accurately.

Preferably, the control device may calculate the electrolyte solution permeation amount Vep based on a temperature of the battery.

The amount of leakage of the electrolyte solution out of the case correlates with the temperature of the battery. According to this configuration, since the electrolyte solution permeation amount Vep is calculated based on the temperature of the battery, the electrolyte solution permeation amount Vep can be calculated accurately.

Preferably, the control device may calculate, based on the battery internal pressure P, a cumulative damage amount ΣDp corresponding to an index of degradation with time of a member constituting the battery, and issue an alarm when the cumulative damage amount ΣDp exceeds a threshold value.

According to this configuration, since the cumulative damage amount ΣDp is calculated based on the accurately calculated battery internal pressure P, it is possible to appropriately estimate degradation with time of the member(s) constituting the battery, and suitably issue an alarm.

The foregoing and other objects, features, aspects and advantages of the present disclosure will become more apparent from the following detailed description of the present disclosure when taken in conjunction with the accompanying drawings.

### BRIEF DESCRIPTION OF THE DRAWINGS

Fig. 1 is an overall configuration diagram of an electrically powered vehicle equipped with a battery system according to the present embodiment.
Fig. 2 is a flowchart showing an example of a battery internal pressure calculation process executed by a battery ECU.
Figs. 3A and 3B are diagrams illustrating a method of calculating the gas generation rate A1.
Figs. 4A and 4B are diagrams illustrating a method of calculating the gas permeation amount Vgp.
Fig. 5 is a graph showing the relationship between the electrolyte solution permeation rate A3 and the temperature TB.
Fig. 6 is a flowchart showing an example of a damage estimation process executed by a control ECU.
Fig. 7 is a diagram showing a calculation map of the gas absorption rate A4.

### DESCRIPTION OF THE PREFERRED EMBODIMENTS

Hereinafter, embodiments of the present disclosure will be described in detail with reference to the drawings. In the drawings, the same or corresponding parts are denoted by the same reference numerals, and the description thereof will not be repeated.

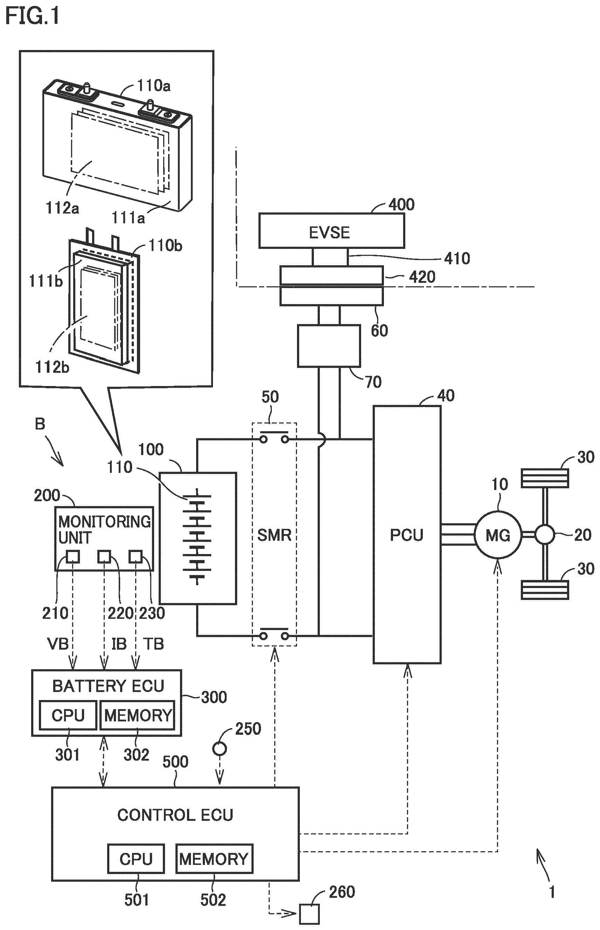

Fig. 1 is an overall configuration diagram of an electrically powered vehicle 1 equipped with a battery system B according to the present embodiment. In the present embodiment, electrically powered vehicle 1 is, for example, a battery electric vehicle. The electrically powered vehicle 1 may be a plug-in hybrid electric vehicle in which an internal combustion engine and a battery are mounted. The electrically powered vehicle 1 includes a motor generator (MG) 10 which is a rotary electric machine, a power transmission gear 20, drive wheels 30, a power control unit (PCU) 40, a system main relay (SMR) 50, a battery 100, a monitoring unit 200, a battery ECU (Electronic Control Unit) 300, and a control ECU 500. The battery ECU 300 and the control ECU 500 correspond to an example of the "control device" of the present disclosure.

The MG 10 is, for example, an embedded permanent magnet synchronous motor (IPM motor), and has a function as an electric motor and a function as a generator. The output torque of the MG 10 is transmitted to the drive wheels 30 via the power transmission gear 20 including a speed reducer, a differential gear, and the like.

During braking of the electrically powered vehicle 1, the MG 10 is driven by the drive wheels 30, and the MG 10 operates as a generator. Accordingly, the MG 10 also functions as a braking device that performs regenerative braking that converts kinetic energy of the electrically powered vehicle 1 into electric power. The regenerative electric power generated by the regenerative braking force in the MG 10 is stored in the battery 100.

The PCU 40 is a power conversion device that bidirectionally converts power between the MG 10 and the battery 100. The PCU 40 includes, for example, an inverter and a converter that operate based on a control signal from the control ECU 500.

The SMR 50 is electrically connected to a power line connecting the battery 100 and the PCU 40. When the SMR 50 is closed (ON) in response to a control signal from the control ECU 500, power can be exchanged between the battery 100 and the PCU 40. On the other hand, when the SMR 50 is opened (OFF) in response to a control signal from the control ECU 500, the electrical connection between the battery 100 and the PCU 40 is cut off.

The battery 100 stores electric power for driving the MG 10. The battery 100 is a rechargeable DC power supply (secondary battery), and is a battery assembly in which a plurality of unit cells (battery cells) 110 are electrically connected in series. The unit cell 110 corresponds to a "battery" of the present disclosure. The unit cell 110 may be composed of, for example, a lithium ion battery.

The unit cell 110 may be, for example, a prismatic battery 110a. In the prismatic battery 110a, an electrode assembly 112a is accommodated in a case 111a formed of a rectangular parallelepiped housing, and an electrolyte solution is sealed therein. The unit cell 110 may be a laminate-type battery (pouch battery) 110b. The laminate-type battery 110b is obtained by sealing an electrode assembly 112b and an electrolyte solution in a case 111b made of a laminate film. The prismatic battery 110a and the laminate-type battery 110b are provided with constituent members such as a discharge valve and a current interruption mechanism. The discharge valve is a safety valve for discharging the gas to the outside when the battery internal pressure rises due to the gas generated inside the battery (inside the case). The current interruption mechanism interrupts the current when the battery abnormally generates heat.

The monitoring unit 200 includes a voltage sensor 210, a current sensor 220, and a temperature sensor 230. The voltage sensor 210 detects the voltage VB of the unit cell 110. The current sensor 220 detects the current IB input to and output from the battery 100 (unit cell 110). When the battery 100 is discharged, the current IB has a negative (-) value, and when the battery 100 is charged, the current IB has a positive (+) value. The temperature sensor 230 detects the temperature TB of the battery 100 (unit cell 110).

The electrically powered vehicle 1 includes an inlet 60. The battery 100 can be externally charged using a charging facility (EVSE: Electric Vehicle Supply Equipment) 400. The inlet 60 is configured to be connectable to a connector 420 provided at the tip of the charging cable 410 of the EVSE 400. The inlet 60 is electrically connected to a power line connected to the battery 100 via the charging circuit 70. In the present embodiment, when the SMR 50 is closed, the inlet 60 and the battery 100 are connected to enable external charging. The charging circuit 70 may include a charging relay. In addition, the inlet 60 (charging circuit 70) may be connected to a power line between the battery 100 and the SMR 50 via a charging relay, and the battery 100 may be externally charged by closing the charging relay.

The battery ECU 300 includes a CPU (Central Processing Unit) 301 and a memory 302. The memory 302 includes a RAM (for example, SRAM (Static Random Access Memory)) and a nonvolatile memory (for example, EEPROM (Electrically Erasable Programmable Read-Only Memory)). When the power supply to the RAM is stopped (when the power supply of the battery ECU 300 is lost), the stored data in the RAM is lost. The nonvolatile memory does not lose the stored data even when the power supply is stopped (even when the power supply of the battery ECU 300 is lost). The battery ECU 300 estimates the SOC of the battery 100 (unit cell 110) using the signal received from the monitoring unit 200, and outputs the estimated SOC to the control ECU 500. The battery ECU 300 estimates the degree of degradation of the battery 100, and outputs the degree of degradation to the control ECU 500. The battery ECU 300 and the control ECU 500 may be connected by, for example, a CAN (Controller Area Network). In the present embodiment, the battery system B includes the battery 100, the monitoring unit 200, the battery ECU 300, the control ECU 500, and the like.

The control ECU 500 includes a CPU 501 and a memory 502. Memory 502, like memory 302, includes a RAM and a nonvolatile memory. Control ECU 500 controls each device so that electrically powered vehicle 1 is in a desired state based on information such as a signal received from battery ECU 300, signals from various sensors (not shown) (e.g., an accelerator operation amount signal, a vehicle speed signal, etc.), and a map and a program stored in memory 502.

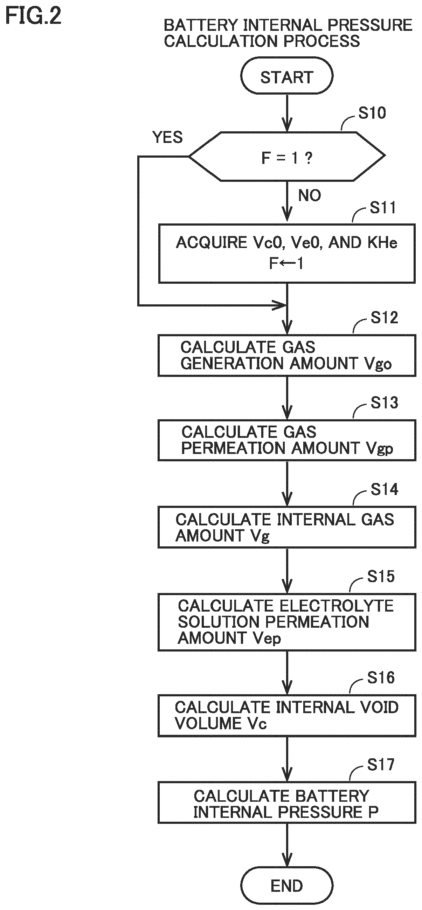

Fig. 2 is a flowchart illustrating an example of a battery internal pressure calculation process executed in the battery ECU 300. This flowchart is executed for each unit cell 110 every predetermined period when the power switch (ignition switch) 250 is turned ON to turn ON the battery system B and when the battery 100 is externally charged by the EVSE 400.

In step (hereinafter, abbreviated as "S") 10, battery ECU 300 determines whether flag F is 1. The flag F is set to "0" at the time of shipment of the electrically powered vehicle 1 and at the time of replacement of the battery 100. When the flag F is 0 and a negative determination is made, the process proceeds to S11, and when the flag F is 1 and an affirmative determination is made, the process proceeds to S12.

In S11, the battery ECU 300 acquires the initial void volume Vc0 and the leakage amount KHe. The initial void volume Vc0 is a volume in which gas can stay inside the case of the unit cell 110. The initial void volume Vc0 is a volume obtained by subtracting the volume of the electrode assembly and the initial electrolyte solution amount Ve0 from the volume inside the case of the unit cell 110. The initial electrolyte solution amount Ve0 is the amount of the electrolyte solution injected into the case in the electrolyte solution injection step of the unit cell 110. The leakage amount KHe is an index value indicating the airtightness of the unit cell 110 obtained in the airtightness inspection step of the unit cell 110. For example, the leakage amount KHe may be a leakage amount obtained by a leak inspection using helium gas.

The process history information is recorded in the two-dimensional code printed on the case surface of the unit cell 110, and the initial void volume Vc0 and the leakage amount KHe may be read from the two-dimensional code and stored in the memory 302 at the time of assembling the battery 100 (battery assembly). In this case, in S11, the initial void volume Vc0 and the leakage amount KHe are read from the memory 302. Alternatively, the process history information of the unit cell 110 may be stored in a server (not shown), and the initial void volume Vc0 and the leakage amount KHe may be acquired from the server by communication between the electrically powered vehicle 1 (the battery ECU 300) and the server when the electrically powered vehicle 1 is activated.

In S12, the battery ECU 300 calculates the gas generation amount Vgo. When the unit cell 110 is charged and discharged, gas is generated due to a decomposition reaction or the like of the electrolyte solution. In S12, the gas generation amount is calculated as the gas generation amount Vgo. In the present embodiment, the gas generation amount Vgo is calculated based on the gas generation rate A1.

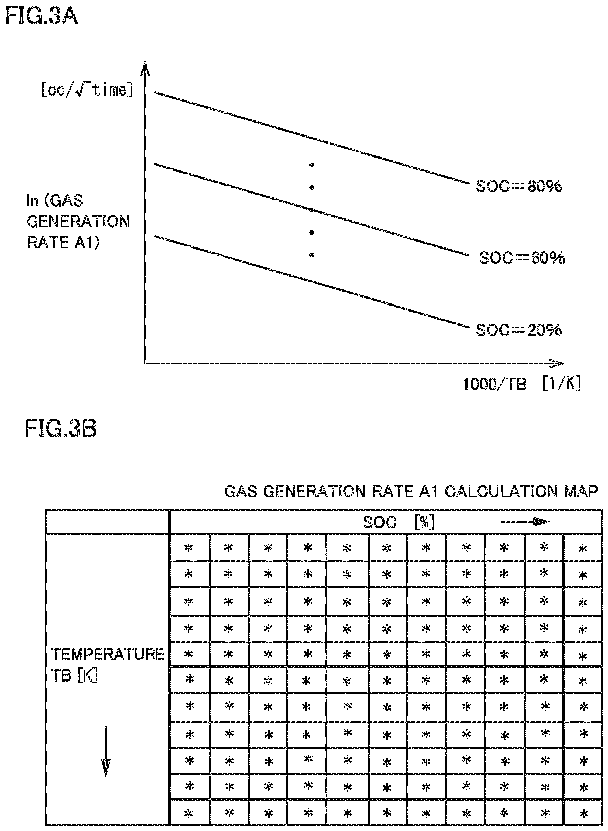

Figs. 3A and 3B are diagrams illustrating a method of calculating the gas generation rate A1. Fig. 3A shows the relationship between the natural logarithm (ln (gas generation rate A1)) of the gas generation rate A1 [cc/√ (time)] and the reciprocal of the temperature TB (1000/TB in the present embodiment) in the unit cell 110. Fig. 3A is known as an Arrhenius plot (Arrhenius equation) and is obtained by experiments and simulations using the unit cell 110. As illustrated in Fig. 3A, for each SOC, the gas generation rate A1 can be approximated to a straight line that increases as the temperature TB increases (as the reciprocal of the temperature TB decreases) or as the SOC increases. For example, the gas generation rate A1 is calculated from the relationship of Fig. 3A using the following equation (1). $A 1 = ln \left(k1\times exp\left(k2\times 1000/TB\right)\right)$ (1)

k1 is a value of an intercept of the vertical axis of Fig. 3A, and k2 is a slope of a straight line, and is set for each SOC. The temperature TB is a value detected by the temperature sensor 230, and the SOC is the current SOC.

Fig. 3B shows a gas generation rate A1 calculation map. Fig. 3B maps the gas generation rate A1 from the relationship among the gas generation rate A1, the temperature TB, and the SOC shown in Fig. 3A. The gas generation rate A1 may be calculated from the map of Fig. 3B using the temperature TB and the SOC as parameters.

The gas generation amount Vgo is calculated from the gas generation rate A1 using the following equation (2). ${Vgo}_{n} = {Vgo}_{n - 1} + \left({A 1}^{2}/\left(2\times {Vgo}_{n - 1}\right)\right) \times dt$ (2)

Vgoₙ is the gas generation amount Vgo (current value) calculated this time, and Vgoₙ₋₁ is the gas generation amount Vgo (previous value) calculated last time. dt is an elapsed time from the previous time to the current time, and corresponds to the calculation cycle of the flowchart of Fig. 2. When the gas generation amount Vgo is calculated in S12, the current value is stored in the nonvolatile memory of the memory 302 as the previous value (Vgoₙ₋₁), and the process proceeds to S13. The initial value of Vgoₙ₋₁ may be "0" or a predetermined value may be set.

In S13, the battery ECU 300 calculates the gas permeation amount Vgp. The gas in the unit cell 110 leaks to the outside from the seal portion or the like. The gas permeation amount Vgp is the amount of gas leaking from the unit cell 110 (case) to the outside. In the present embodiment, the gas permeation amount Vgp is calculated based on the gas permeation rate A2.

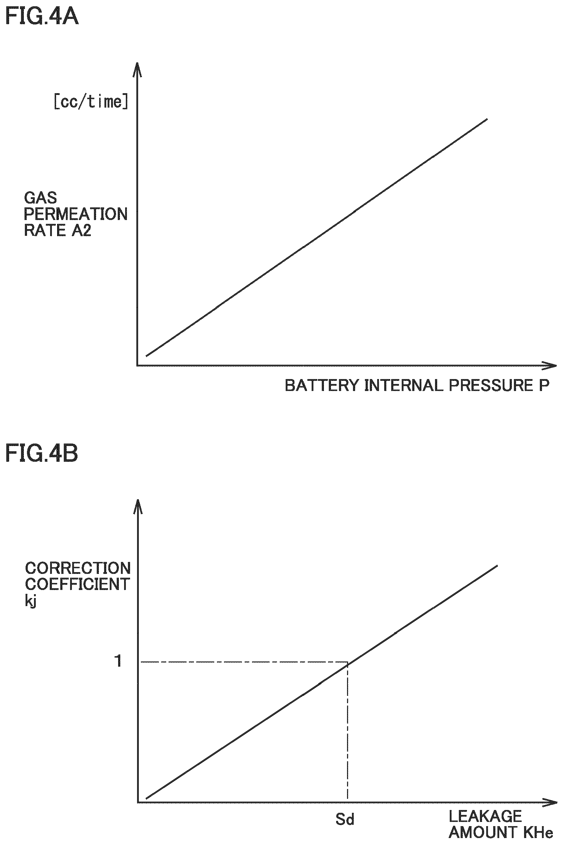

Figs. 4A and 4B are diagrams illustrating a method of calculating the gas permeation amount Vgp. Fig. 4A shows the relationship between the gas permeation rate A2 [cc/time] and the battery internal pressure P in the unit cell 110. As shown in Fig. 4A, the gas permeation rate A2 is proportional to the battery internal pressure P. From the relationship of Fig. 4A, the gas permeation rate A2 is calculated using the following equation (3). $A 2 = k 3 \times {P}_{n - 1} \times kj$ (3)

Pₙ₋₁ is the previously calculated battery internal pressure P. k3 is a constant and is the slope of the straight line shown in Fig. 4A. Here, kj is a correction coefficient.

Fig. 4B is a diagram illustrating the correction coefficient kj. The relationship between the gas permeation rate A2 and the battery internal pressure P shown in Fig. 4A is a relationship (experimental value) in the case where the leakage amount KHe of the unit cell 110 (index value representing airtightness of the unit cell) is the reference value Sd. When the leakage amount KHe of the unit cell 110 is larger than the reference value Sd, the slope of the straight line shown in Fig. 4A becomes large. On the other hand, when the leakage amount KHe of the unit cell 110 is smaller than the reference value Sd, the slope of the straight line shown in Fig. 4A becomes small. Therefore, as shown in Fig. 4B, the correction coefficient kj becomes "1" when the leakage amount KHe of the unit cell 110 is the reference value Sd. When the leakage amount KHe is smaller than the reference value Sd, the correction coefficient kj becomes a value smaller than 1, and when the leakage amount KHe is larger than the reference value Sd, the correction coefficient kj becomes a value larger than 1. The correction coefficient kj is obtained from Fig. 4B using the leakage amount KHe acquired in S11.

The gas permeation amount Vgp is calculated from the gas permeation rate A2 using the following equation (4). ${Vgp}_{n} = A 2 \times dt + {Vgp}_{n - 1}$ (4)

Vgpₙ is the gas permeation amount Vgp (current value) calculated this time, and Vgpₙ₋₁ is the gas permeation amount Vgp (previous value) calculated last time. dt is an elapsed time from the previous time to the current time, and corresponds to the calculation cycle of the flowchart of Fig. 2. When the gas permeation amount Vgp is calculated in S13, the current value is stored in the nonvolatile memory of the memory 302 as the previous value (Vgpₙ₋₁), and the process proceeds to S14. The initial value of Vgpₙ₋₁ may be "0" or a predetermined value may be set.

In S14, the battery ECU 300 calculates the internal gas amount Vg. The internal gas amount Vg is calculated using the following equation (5). $Vg = {Vgo}_{n} - {Vgp}_{n}$ (5)

Vgoₙ is the gas generation amount Vgo calculated this time in S12, and Vgpₙ is the gas permeation amount Vgp calculated this time in S13.

In subsequent S15, the battery ECU 300 calculates the electrolyte solution permeation amount Vep. The electrolyte solution in the unit cell 110 leaks to the outside from the seal portion or the like. The electrolyte solution permeation amount Vep is the amount of electrolyte solution leaking from the unit cell 110 (case) to the outside. In the present embodiment, the electrolyte solution permeation amount Vep is calculated based on the electrolyte permeation rate A3.

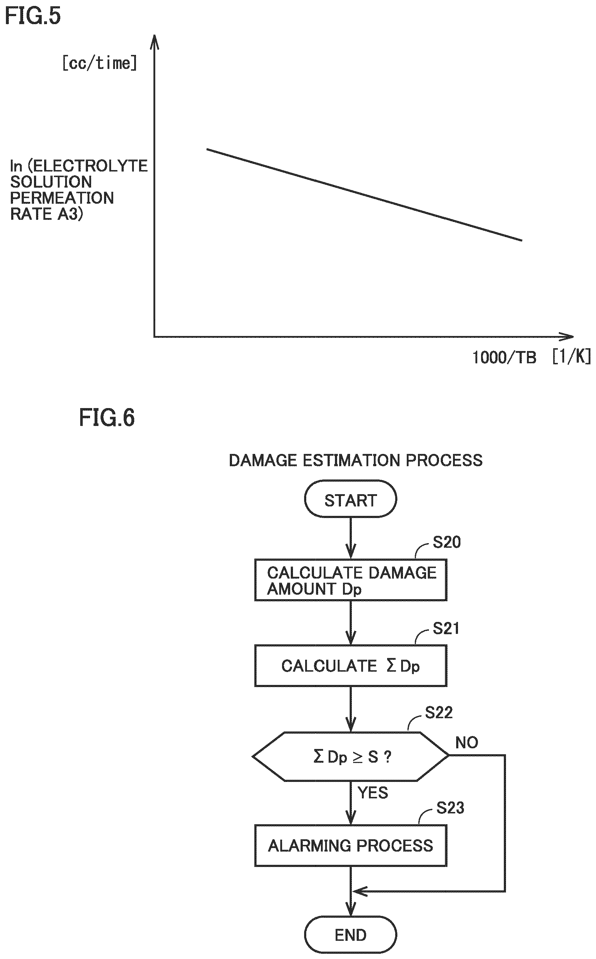

Fig. 5 is a graph showing the relationship between the natural logarithm of the electrolyte solution permeation rate A3 (In (electrolyte solution permeation rate A3)) and the reciprocal of the temperature TB (1000/TB in the present embodiment). The electrolyte solution permeation rate A3 [cc/time] increases as the temperature TB increases (as the reciprocal of the temperature TB decreases). The electrolyte solution permeation rate A3 is calculated from the relationship of Fig. 5 using the following equation (6). $A 3 = ln \left(k4\times exp\left(k5\times 1000/TB\right)\right)$ (6)

k4 and k5 are constants, and the temperature TB is a value detected by the temperature sensor 230. The constants k4 and k5 are determined according to the composition (viscosity, vapor pressure, etc.) of the electrolyte solution and the structure of the electrolyte solution seal portion, for example.

The electrolyte solution permeation amount Vep is calculated from the electrolyte solution permeation rate A3 using the following equation (7). ${Vep}_{n} = A 2 \times dt + {Vep}_{n - 1}$ (7)

Vepₙ is the electrolyte solution permeation amount Vep (current time value) calculated this time, and Vepₙ₋₁ is the electrolyte solution permeation amount Vep (previous time value) calculated last time. dt is an elapsed time from the previous time to the current time, and corresponds to the calculation cycle of the flowchart of Fig. 2. When the electrolyte solution permeation amount Vep is calculated in S15, the current value is stored in the nonvolatile memory of the memory 302 as the previous value (Vepₙ₋₁), and the process proceeds to S16. The initial value of Vepₙ₋₁ may be "0" or a predetermined value may be set.

In S16, the battery ECU 300 calculates the internal void volume Vc. The internal void volume Vc is currently the volume of gas that can stay inside the case of the unit cell 110. The internal void volume Vc is calculated from the following equation (8). $Vc = Vc 0 + {Vep}_{n}$ (8)

Vc0 is the initial void volume Vc0 acquired in S11. Vepₙ is the current electrolyte solution permeation amount Vep calculated in S16. The internal void volume Vc is calculated by adding the electrolyte solution permeation amount Vep to the initial void volume Vc0.

In S17, the battery ECU 300 calculates the battery internal pressure P. The battery internal pressure P is calculated using the following equation (9). $P = Vg / Vc$ (9)

Vg is the internal gas amount Vg calculated in S14, and Vc is the internal void volume Vc calculated in S16. When S17 is processed, the current routine is ended.

Fig. 6 is a flowchart showing an example of a damage estimation process executed by the control ECU 500. This flowchart is executed for each unit cell 110 every predetermined period when the power switch 250 is turned ON and the battery system B is turned ON and when the battery 100 is externally charged by the EVSE 400. In S20, the control ECU 500 calculates the damage amount Dp of the unit cell 110. The calculation of the damage amount Dp is substantially the same as the calculation method described in the Japanese Patent Laying-Open No. 2015-141790. The damage amount Dp is calculated from the temperature TB and the battery internal pressure P calculated in the battery internal pressure calculation process of Fig. 2. In the present embodiment, the damage amount Dp is a factor affecting the creep destruction of the members (constituent members) constituting the unit cell 110, and for example, a current interruption mechanism is targeted as a component.

The damage amount Dp is stored in the memory 502 as a map in which the temperature TB and the battery internal pressure P are used as parameters, and is set to a larger value as the temperature TB is higher and as the battery internal pressure P is higher, for example. In S20, the damage amount Dp is calculated from the temperature TB and the battery internal pressure P.

In subsequent S21, the control ECU 500 calculates the integrated damage ΣDp by integrating the damage amount Dp calculated in S20 (ΣDp=ΣDpₙ₋₁+Dp, where ΣDpₙ₋₁ is the previous value of ΣDp.).

In S22, the control ECU 500 determines whether or not the integrated damage ΣDp is equal to or greater than the threshold value S. When the integrated damage ΣDp is equal to or greater than the threshold value S (ΣDp≥S), the process proceeds to S23. When the integrated damage ΣDp is smaller than the threshold value S (ΣDp<S), the current routine is ended.

In S23, the control ECU 500 turns on MIL (Malfunction Indicator Lamp) 260, issues an alarm, and ends the current routine.

According to the present embodiment, the internal gas amount Vg is calculated by subtracting the gas permeation amount Vgp corresponding to the amount of gas leaking out of the case from the gas generation amount Vgo generated in the case of the unit cell 110. The internal void volume Vc is calculated by adding the electrolyte solution permeation amount Vep corresponding to the amount of the electrolyte solution leaking out of the case to the initial void volume Vc0 in the case. Since the battery internal pressure P is calculated from the internal gas amount Vg and the internal void volume Vc, the battery internal pressure P can be calculated in consideration of the gas leaking from the case of the unit cell 110 and the electrolyte solution, and the calculation accuracy of the battery internal pressure P can be improved.

According to the present embodiment, the gas permeation amount Vgp is calculated using the gas permeation rate A2 calculated based on the leakage amount KHe and the battery internal pressure P. Therefore, the gas permeation rate A2 correlated with the airtightness of the case can be accurately calculated, and the calculation accuracy of the battery internal pressure P can be improved.

In the present embodiment, the cumulative damage amount ΣDp is calculated based on the battery internal pressure P, and when the cumulative damage amount ΣDp exceeds the threshold value S, the MIL 260 is turned on. Since the cumulative damage amount ΣDp is calculated on the basis of the battery internal pressure P calculated with high accuracy, it is possible to appropriately estimate the degradation with time of the member(s) constituting the unit cell 110, and it is possible to suitably issue an alarm.

In the above embodiment, the battery ECU 300 executes the battery internal pressure calculation process (Fig. 2), and the control ECU 500 executes the damage estimation process (Fig. 6). However, these processes may be executed by one of the battery ECU 300 and the control ECU 500, or may be executed by the battery ECU 300 and the control ECU 500 in cooperation with each other.

In the above-described embodiment, the correction coefficient kj is obtained from Fig. 4B when the gas permeation rate A2 is calculated using the equation (3), but the gas permeation rate A2 may be calculated without using the correction coefficient kj. For example, the gas permeation rate A2 may be calculated with the correction coefficient kj=1.

### (Modification)

A part of the gas generated during charging and discharging of the unit cell 110 is absorbed by the electrolyte solution. Depending on the characteristics (types) of the unit cell 110, the amount of gas absorbed into the electrolyte solution may not be negligible. In the modification, the battery internal pressure P is calculated in consideration of the amount of gas absorbed into the electrolyte solution.

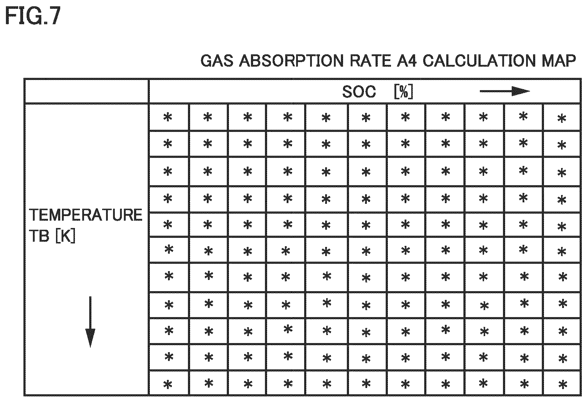

Fig. 7 is a diagram showing a calculation map of the gas absorption rate A4. The gas absorption rate A4 [cc/time] is an absorption rate of the gas absorbed by the electrolyte solution of the unit cell 110. The gas absorption rate A4 is previously mapped by experiments or the like using the temperature TB and the SOC as parameters. For example, after the process of S13 (see Fig. 2), the gas absorption rate A4 is obtained from the temperature TB and the SOC using the gas absorption rate A4 calculation map, and the gas absorption amount Vga is calculated using the following equation (10). ${Vga}_{n} = A 4 \times dt + {Vga}_{n - 1}$ (10)

Vgaₙ is the gas absorption amount Vga (current value) calculated this time, and Vgaₙ₋₁ is the gas absorption amount Vga (previous value) calculated last time. dt is an elapsed time from the previous time to the current time, and corresponds to the calculation cycle of the flowchart of Fig. 2.

In this modification, in S14, the internal gas amount Vg is calculated using the following equation (11). $Vg = {Vgo}_{n} - {Vgp}_{n} - {Vga}_{n}$ (11)

In the modification, the internal gas amount Vg is obtained by subtracting the presently calculated gas permeation amount Vgpₙ and the presently calculated gas absorption amount Vgaₙ from the presently calculated gas generation amount Vgoₙ. Then, in S17, the battery internal pressure P is calculated using the equation (9).

According to this modification, since the battery internal pressure P is calculated in consideration of the amount of gas absorbed into the electrolyte solution, the calculation accuracy of the battery internal pressure P can be improved.

Although the present disclosure has been described and illustrated in detail, it is clearly understood that the same is by way of illustration and example only and is not to be taken by way of limitation, the scope of the present disclosure being interpreted by the terms of the appended claims.

## Claims

1. A battery system comprising:
a battery (110) in which an electrode assembly (112a; 112b) and an electrolyte solution are housed in a case (111a; 111b); and
a control device (300, 500), wherein
the control device
calculates an internal gas amount (Vg) that is a gas amount inside the battery, by subtracting, from a generation amount (Vgo) of gas generated in the case, a gas permeation amount (Vgp) corresponding to an amount of leakage of the gas out of the case,
calculates an internal void volume (Vc) that is a void volume inside the battery, by adding, to an initial void volume (Vc0) in the case, an electrolyte solution permeation amount (Vep) corresponding to an amount of leakage of the electrolyte solution out of the case, and
calculates a battery internal pressure (P) that is a pressure in the case, based on the internal gas amount and the internal void volume.

2. The battery system according to claim 1, wherein the control device calculates the internal gas amount by subtracting, from the generation amount, the gas permeation amount and a gas absorption amount (Vga) that is an amount of absorption of the gas by the electrolyte solution.

3. The battery system according to claim 1, wherein the control device calculates the gas permeation amount based on the battery internal pressure.

4. The battery system according to claim 3, wherein
the control device
calculates a gas permeation rate (A2) that is an amount of the gas leaking out of the case per unit time, based on the battery internal pressure and an index value representing airtightness of the battery, and
calculates the gas permeation amount based on the gas permeation rate.

5. The battery system according to any one of claims 1 to 4, wherein the control device calculates the electrolyte solution permeation amount based on a temperature of the battery.

6. The battery system according to any one of claims 1 to 4, wherein
the control device
calculates, based on the battery internal pressure, a cumulative damage amount (ΣDp) corresponding to an index of degradation with time of a member constituting the battery, and
issues an alarm when the cumulative damage amount exceeds a threshold value.

## Patentansprüche

1. Batteriesystem mit:
einer Batterie (110), in der eine Elektrodenanordnung (112a; 112b) und eine Elektrolytlösung in einem Gehäuse (111a; 111b) untergebracht sind, und
einer Steuervorrichtung (300, 500), wobei
die Steuervorrichtung
eine interne Gasmenge (Vg) berechnet, bei der es sich um eine Gasmenge im Inneren der Batterie handelt, indem sie von einer im Gehäuse erzeugten Gasmenge (Vgo) eine Gaspermeationsmenge (Vgp) subtrahiert, die einer Entweichungsmenge des Gases aus dem Gehäuse entspricht,
ein internes Hohlraumvolumen (Vc) berechnet, bei dem es sich um ein Hohlraumvolumen im Inneren der Batterie handelt, indem sie zu einem anfänglichen Hohlraumvolumen (Vc0) im Gehäuse eine Elektrolytlösungs-Permeationsmenge (Vep) addiert, die einer Entweichungsmenge der Elektrolytlösung aus dem Gehäuse entspricht, und
einen Batterieinnendruck (P), beim dem es sich um einen Druck im Gehäuse handelt, auf der Grundlage der internen Gasmenge und des internen Hohlraumvolumens berechnet.

2. Batteriesystem nach Anspruch 1, wobei die Steuervorrichtung die interne Gasmenge berechnet, indem sie von der erzeugten Gasmenge die Gaspermeationsmenge und eine Gasabsorptionsmenge (Vga) abzieht, bei der es sich um eine von der Elektrolytlösung absorbierte Gasmenge handelt.

3. Batteriesystem nach Anspruch 1, wobei die Steuervorrichtung die Gaspermeationsmenge auf der Grundlage des Batterieinnendrucks berechnet.

4. Batteriesystem nach Anspruch 3, wobei
die Steuervorrichtung
eine Gaspermeationsrate (A2), bei der es sich um eine pro Zeiteinheit aus dem Gehäuse entweichende Gasmenge handelt, auf der Grundlage des Batterieinnendrucks und eines die Luftdichtheit der Batterie repräsentierenden Indexwerts berechnet, und
die Gaspermeationsmenge auf der Grundlage der Gaspermeationsrate berechnet.

5. Batteriesystem nach einem der Ansprüche 1 bis 4, wobei die Steuervorrichtung die Elektrolytlösungs-Permeationsmenge auf der Grundlage einer Temperatur der Batterie berechnet.

6. Batteriesystem nach einem der Ansprüche 1 bis 4, wobei
die Steuereinrichtung
auf der Grundlage des Batterieinnendrucks eine kumulative Schadensmenge (ΣDp) berechnet, die einem Index für die zeitliche Verschlechterung eines die Batterie bildenden Bauteils entspricht, und
einen Alarm auslöst, wenn die kumulative Schadensmenge einen Schwellenwert überschreitet.

## Revendications

1. Système de batterie comprenant :
une batterie (110) dans laquelle un ensemble d'électrodes (112a ; 112b) et une solution électrolytique sont logés dans un boîtier (111a ; 111b) ; et
un dispositif de commande (300, 500), dans lequel
le dispositif de commande
calcule une quantité de gaz interne (Vg) qui est une quantité de gaz à l'intérieur de la batterie, en soustrayant, d'une quantité de génération (Vgo) de gaz généré dans le boîtier, une quantité de perméation de gaz (Vgp) correspondant à une quantité de fuite du gaz hors du boîtier,
calcule un volume de vide interne (Vc) qui est un volume de vide à l'intérieur de la batterie, en ajoutant, à un volume de vide initial (Vc0) dans le boîtier, une quantité de perméation de solution électrolytique (Vep) correspondant à une quantité de fuite de la solution électrolytique hors du boîtier, et
calcule une pression interne de batterie (P) qui est une pression dans le boîtier, sur la base de la quantité de gaz interne et du volume de vide interne.

2. Système de batterie selon la revendication 1, dans lequel le dispositif de commande calcule la quantité de gaz interne en soustrayant, de la quantité de génération, la quantité de perméation de gaz et une quantité d'absorption de gaz (Vga) qui est une quantité d'absorption du gaz par la solution électrolytique.

3. Système de batterie selon la revendication 1, dans lequel le dispositif de commande calcule la quantité de perméation de gaz sur la base de la pression interne de batterie.

4. Système de batterie selon la revendication 3, dans lequel
le dispositif de commande
calcule un taux de perméation de gaz (A2) qui est une quantité du gaz s'échappant du boîtier par unité de temps, sur la base de la pression interne de batterie et d'une valeur d'indice représentant l'étanchéité à l'air de la batterie, et
calcule la quantité de perméation de gaz sur la base du taux de perméation de gaz.

5. Système de batterie selon l'une quelconque des revendications 1 à 4, dans lequel le dispositif de commande calcule la quantité de perméation de solution électrolytique sur la base de la température de la batterie.

6. Système de batterie selon l'une quelconque des revendications 1 à 4, dans lequel
le dispositif de commande
calcule, sur la base de la pression interne de batterie, une quantité cumulée de dommages (ΣDp) correspondant à un indice de dégradation au fil du temps d'un élément constituant la batterie, et
déclenche une alarme lorsque la quantité cumulée de dommages dépasse une valeur seuil.
